# EUROPEAN PATENT SPECIFICATION

(11) **EP 3 005 024 B1**
(45) Date of publication and mention of the grant of the patent: **08.08.2018**
(21) Application number: 14741367.8
(22) Date of filing: 23.05.2014
(51) Int. Cl.: G06F 1/32, G06F 3/02, H01H 9/16, H01H 23/02, H03K 17/955, H03K 17/96, H01H 9/18, H02G 3/12, H02G 3/14

(54) **A CONTROL UNIT FOR CONTROLLING AN ELECTRICAL APPARATUS**
STEUEREINHEIT ZUR STEUERUNG EINER ELEKTRISCHEN VORRICHTUNG
UNITÉ DE COMMANDE POUR COMMANDE D'APPAREIL ÉLECTRIQUE

(30) Priority: 24.05.2013 IT PD20130145
(43) Date of publication of application: 13.04.2016
(73) Proprietor: Vimar SpA, 36063 Marostica (VI) (IT)
(72) Inventor: GUSI, Piero Camillo, 36063 Marostica (IT)
(74) Representative: Locas, Davide
(86) International application number: PCT/IB2014/061656
(87) International publication number: WO 2014/188384

(56) References cited:
- EP-A1- 1 691 263
- WO-A1-2010/131155
- WO-A1-2012/137876
- WO-A2-2005/019987
- GB-A- 2 470 423
- US-A- 6 140 987
- US-A1- 2007 146 348
- US-B1- 6 396 007
- "Zennio Touch-MyDesign. KNX Capacitive Touch Switch ZN1VI-TPTMD4, ZN1VI-TPTMD6, ZN1VI-TPTMD8. Technical Documentation", , 2 May 2013 (2013-05-02), XP055097803, Retrieved from the Internet: URL:http://knxshop.co.uk/catalog/infofiles /Datasheet_TouchMyDesign_EN_Ed1.pdf [retrieved on 2014-01-22]
- "ZENNIO Touch-MyDesign KNX Capacitive Touch Switch - 6 Buttons", , 2 May 2013 (2013-05-02), XP055097804, Retrieved from the Internet: URL:http://knxshop.co.uk/catalog/Catalog.a spx?NavID=043-006-1030-ZNNZN1VITPTMD6&Part =ZENNIO-ZENNIO-Touch-MyDesign-KNX-Capaciti ve-Touch-Switch---6-Buttons [retrieved on 2014-01-22]

## Description

The invention relates to a control unit for an electrical apparatus, of the type comprising a control device which may be wall-mounted and an actuation plate which may be secured thereto.

It is known in the reference sector to use switches and other types of controls for an electrical apparatus which may be wall-mounted.

These switches are typically used in electrical apparatuses, which may be domestic or industrial, in order to control lights or other appliances, such as electric blinds, or to open (and close) doors and gates.

The switch is provided with a terminal block to which the electrical cables connected to the apparatus to be controlled are connected and is wall-mounted by means of an appropriate support, normally box-shaped, secured in a fixed manner to the wall.

In a first type of switch, the apparatus is actuated in an electromechanical manner by acting on a push button which may move between a first position in which an electrical contact is closed and a second position in which the contact is open. As an alternative to electromechanical switches, control devices are also known which use a contact sensor which, by means of an appropriate electronic circuit, controls the apparatus in order, for instance, to turn it on or off by touching a specific part of an external contact surface of the device.

The external surface may contain different touch zones, each associated with a specific function of the control device. There may, for instance, be two zones, one above the other, which make it possible to turn a light on or off, reflecting the way in which electromechanical switches are operated.

The external surface is thus made from transparent material, so as to enable the display of graphical symbols disposed below the contact surface which make it possible to identify the specific function associated with contact with the surface portion lying above the symbol.

Known touch control devices nevertheless have some drawbacks which mean that they are not very suitable for wide-ranging uses.

A first drawback lies in the fact that it is very difficult to personalize the graphical symbols used or other visible components in known touch control devices.

An example of such solution is disclosed in GB 2470423, relating to a control device fixable to a wall mounting box comprising a LCD display and a touch control system. It is evident that this device does not allow any customization but by substituting the LCD display and the touch control associated thereto. As an alternative, a customization can be achieved by using a programmable system, nevertheless with a remarkable cost increase. Similar solutions are also disclosed in US 6,396,007 and in "Zennio Touch-MyDesign. KNX Capacitive Touch Switch ZN1VI-TPTMD4, ZN1VI-TPTMD6, ZN1VI-TPTMD8. Technical Documentation" by Zennio Avance y Technologia S.L. An alternative solution is disclosed in WO 2012/137876 A1, wherein graphical symbols (331, 332) are illuminated by light emitted by a source (31) and guided by a light guide (43). In particular, when the device is formed as a single body, i.e. a preassembled set of components which cannot be dismantled, it is not possible for the installer to personalize the device.

As an alternative, the contact surface may be defined on a detachable plate so that it can be readily replaced and therefore personalized, and so that the graphical symbols below it can be readily modified.

However, the thickness of the plate does not just make the contact sensor less sensitive but also means that the graphical elements below it cannot be read in a clear enough way.

A second drawback lies in the problem of compensating for any irregularities in the wall or positioning errors as regards the supports that are also used in control devices of the touch type in order to secure them to the wall.

It will be appreciated in this respect that touch control devices are also mounted on a wall by means of a support box which is rigidly secured to the wall, in the same way as electromechanical switches, and positioning errors of the box can easily occur during its installation.

This may mean that the plate does not fully adhere to the wall, when the device is formed by a single body, or that there is incomplete contact between the plate and the components secured to the wall by means of the support box when the device has a plate which may be replaced.

In this latter case, the sensitivity of the contact sensor may be further compromised and it may be even more difficult to read the graphical symbols because of the distance between the symbols and the transparent surface.

The technical problem underlying the present invention is one of providing a control unit which may be wall-mounted for the control of electrical apparatus which is structurally and functionally designed to remedy all the drawbacks discussed with respect to the cited prior art.

This problem is resolved by a control unit for controlling an electrical apparatus according to claim 1.

Preferred features of the invention are disclosed in the dependent claims.

The present invention enables simple and practical personalization and is able effectively to compensate for any errors occurring during the installation of the support structure on the wall or any irregularities in the wall itself.

According to a further aspect, in a preferred embodiment, the present invention also refers to a control assembly for controlling an electrical apparatus, comprising:
- a wall-mountable control device;
- an operating plate connected or connectable to the control device and in which there is defined an at least partly transparent cover surface, the cover surface being, when in use, arranged for the covering of the control assembly and of a portion of a wall on which the control device is mounted;
- an illuminating device beneath the cover surface and suitable for illuminating a touch zone of the operating plate;
- a contact sensor device for detecting a contact action by a finger of a user or other body at the touch zone;
- a control unit for controlling the electrical apparatus as a function of the detection of the contact action;
- a proximity sensor device able to execute a variation of light intensity of the illuminating device following an approaching action of a finger of the user, or other body, within a predetermined distance.

According to this aspect, the present invention allows to display in a clear and well-evident manner the position of the touch zones provided for controlling the electrical apparatus, without annoying the user and, as a consequence, being usable also in environments in which it is appropriate to avoid the presence of light sources.

Furthermore, the invention as defined according to this further aspect allows to obtain a considerable energy saving with respect to the devices according to the prior art.

The features and further advantages of the invention will become clear from the following detailed description of a preferred but not exclusive embodiment thereof, shown by way of non-limiting example in the appended drawings, in which:
- Fig. 1 is an exploded perspective view of a control unit of the present invention associated with a relative fastening frame;
- Fig. 2 is an exploded perspective view of an actuation plate of the control unit of Fig. 1;
- Figs. 3A and 3B are respectively a perspective view and a lateral view of the actuation plate of Fig. 2;
- Fig. 4 is a rear perspective view of a detail of the actuation plate of Fig. 2;
- Figs. 5 and 5A are a perspective view and a corresponding exploded view of a control device forming part of the control unit of Fig. 1;
- Fig. 6 is a front view of the control unit of the present invention secured to the relative fastening frame with the actuation plate removed;
- Figs. 7 and 7A are respectively a view in lateral section and a relative detail of the control unit of the present invention.

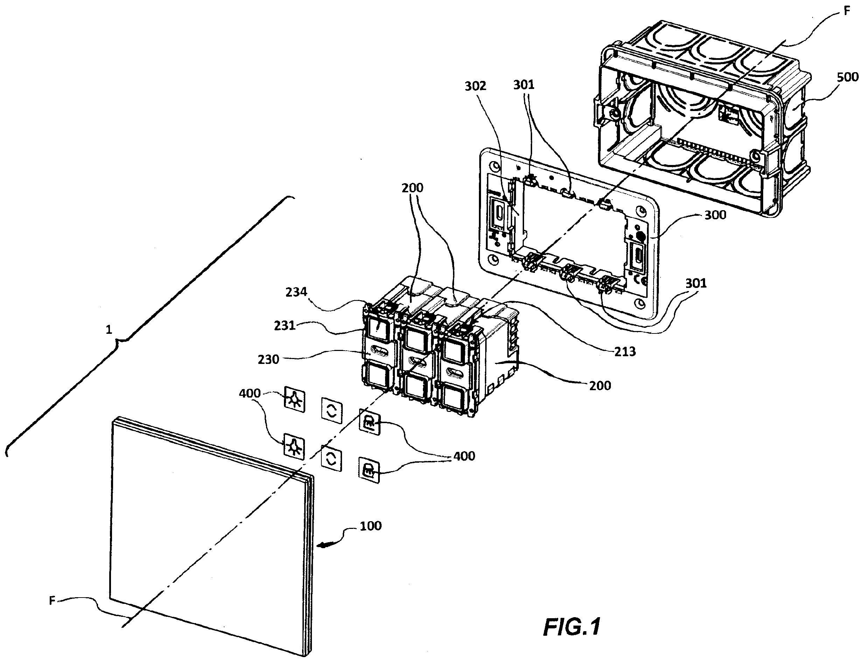

With reference first to Fig. 1, a control unit for an electrical apparatus, of the type which may be wall-mounted, is shown overall by reference numeral 1.

The control unit 1 comprises one or a plurality of control devices 200 and an actuation plate 100 which may be secured to the control device 200 by methods which will be described in further detail below.

The control unit is preferably fastened to the wall by means of a fastening frame 300, for instance of a type similar to those used in switches embodied in accordance with the prior art, typically in conjunction with a box-shaped body 500.

In order to install the control unit of the present invention, the box-shaped body 500 is secured in a permanent manner in a cavity in the wall, for instance by mortar or other appropriate building materials.

The fastening frame 300 is then connected, advantageously in a detachable manner, for instance by means of a threaded connection, to the box-shaped body 500, thereby defining a seat for housing the control device 200.

According to a preferred embodiment, a snap-locking connection is provided between the control device 200 and the fastening frame 300 so as to enable these components to be connected by sliding the control device 200 within the frame in a fastening direction F.

By way of example, the snap-locking connection may be embodied as a flexible pawl 301 (or preferably a plurality of pawls 301) disposed along an inner edge 302 of the frame 300 which engages in a respective seat 213 provided in the control device 200.

This type of connection is advantageous in that the actuation unit 1 of the present invention may be modular in form, enabling the use of a series of individual modules, each defined by a respective control device 200, on a single fastening frame 300 and, as will be described in further detail below, in association with a single actuation plate 100. In the present embodiment, there are, for instance, three control devices 200 alongside one another.

The actuation plate 100 may also be secured to the control unit 200 directly or by means of the support frame 300, by means of methods which will be described below, but preferably by pressing it against the control unit 200 in the fastening direction F.

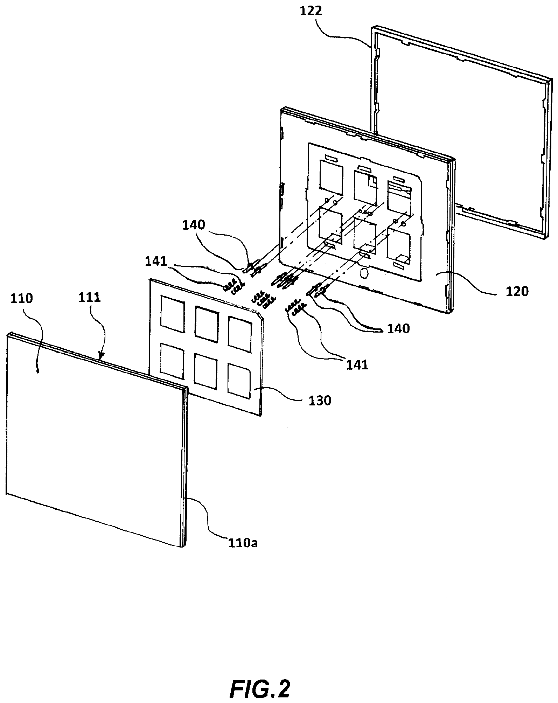

With reference to Fig. 2 as well, the actuation plate 100 comprises a support frame 120 and a relative cornice 122 to which a plate 110a which defines a cover surface 110 is secured. The plate 110a is preferably made from glass or another transparent material and has dimensions such that when the plate is secured to the control unit 200, the cover surface 110 is disposed to cover the control unit 200 and a portion of the wall surrounding the control device 200 and the relative fastening frame 300.

The plate 110a, although made from transparent material, preferably has an opaque coating which enables light to pass through at least partially, for reasons that will be explained below, but nevertheless conceals the details of the components lying below the plate 110a from sight. This effect may be obtained, for instance, by a silk-screen technique.

A sensor member 130 defining contact sensor device able to detect contact between a user's finger and the cover surface 110 is further provided between the plate 110a and the support frame 120.

The sensor member 130 preferably comprises first capacitor members such that contact by a finger or other body or means is detected by a variation of electrical capacitance of the capacitor members that takes place when the cover surface 110 is touched.

It will nevertheless be appreciated that use may be made of different types of sensor members 130 which are able to supply a signal detecting a contact action at a specific position of the cover surface 110.

In addition, the actuation plate 100 comprises electrical connection means designed to provide an electrical connection between the plate 100 and the control device 200.

According to a preferred embodiment, the electrical connection means comprise an electrical connector 140, preferably in the form of a pin, housed in a sliding manner in a seat 124 defined in the support frame 120.

The seat 124 extends longitudinally in parallel with the fastening direction F in such a way as to enable the electrical connector 140 to be moved in that direction.

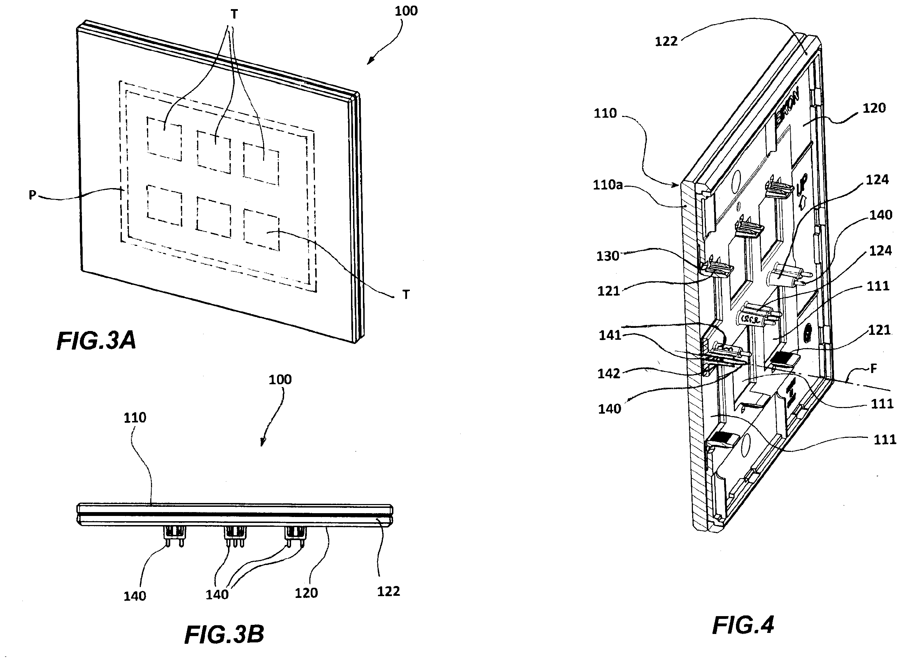

As can be seen from Fig. 4, the pin 140 forming the electrical connector advantageously has a shoulder 142 which makes it possible to lock a helical spring 141 and to define an end of stroke for the pin 140, retaining it within the relative seat 124.

The helical spring 141, or other equivalent resilient means, makes it possible to oppose the displacement of the pin 140 towards the interior of the seat 124, forcing it towards its position of maximum extension. The spring 141 is of electrically conducting material and is disposed to bear on the sensor member 130 so as to connect it electrically to the control device 200.

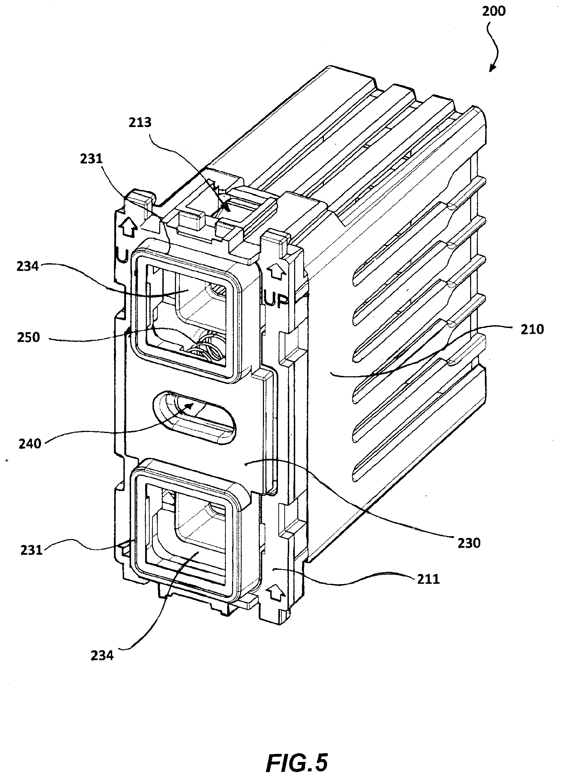

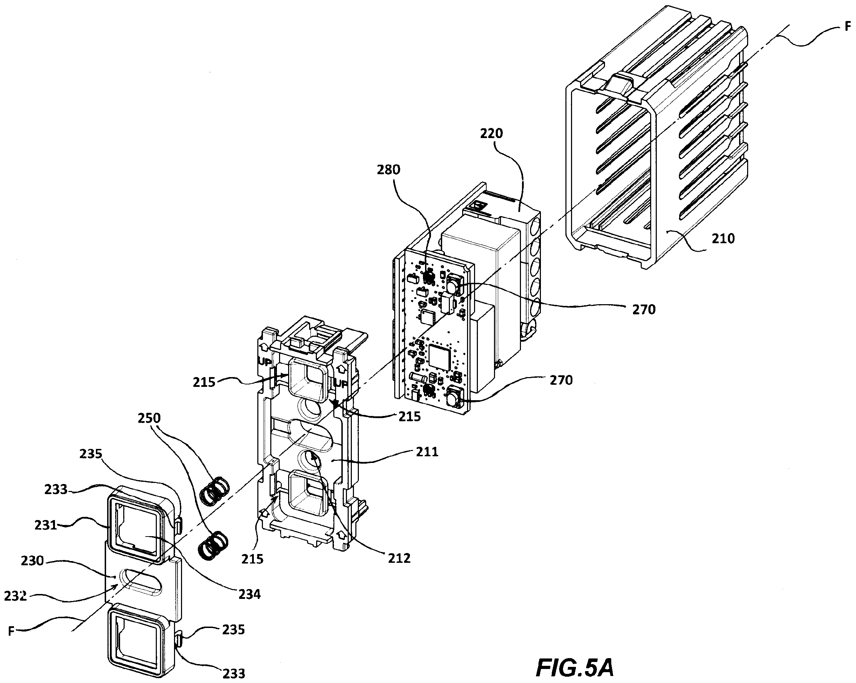

With reference to Figs. 5 and 5A, the control device 200 comprises a base structure 210 which defines a housing within which a controlling unit 280, formed for instance by an electronic circuit board, is housed and is designed to process a signal supplied by the sensor member 130 and a terminal block 220 for the electrical connection with the apparatus to be controlled.

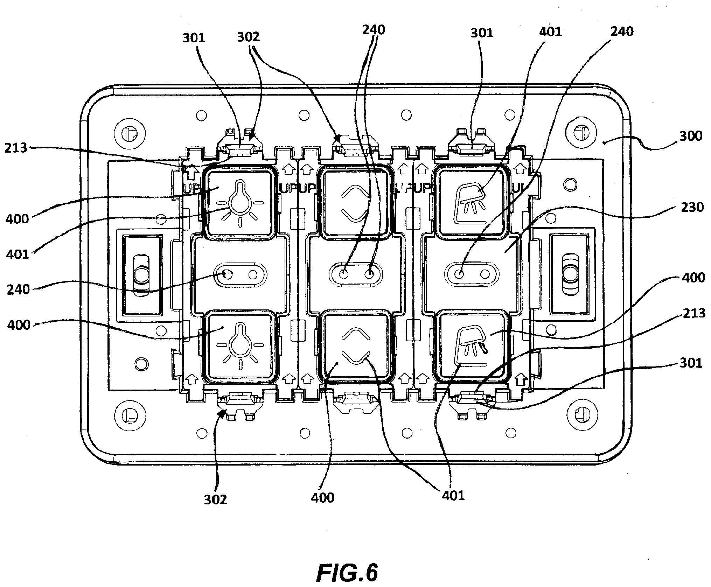

The base structure 210 preferably comprises a front body 211 in which an opening 212 is provided for the passage of the pin 140 so as to enable contact between the latter and a conducting surface 240 of the control device 200, as shown in Fig. 6.

The contact between the pin 140 and the surface 240 makes it possible to supply electrical power to the actuation plate 100 and to transmit a signal designed to detect a contact action supplied by the sensor member 130.

The control device 200 further comprises a an abutment member 230 which may also move in the fastening direction F with respect to the base structure 210. A pair of edges 231 which extend in a direction away from the base structure 210 are defined on the abutment member 230.

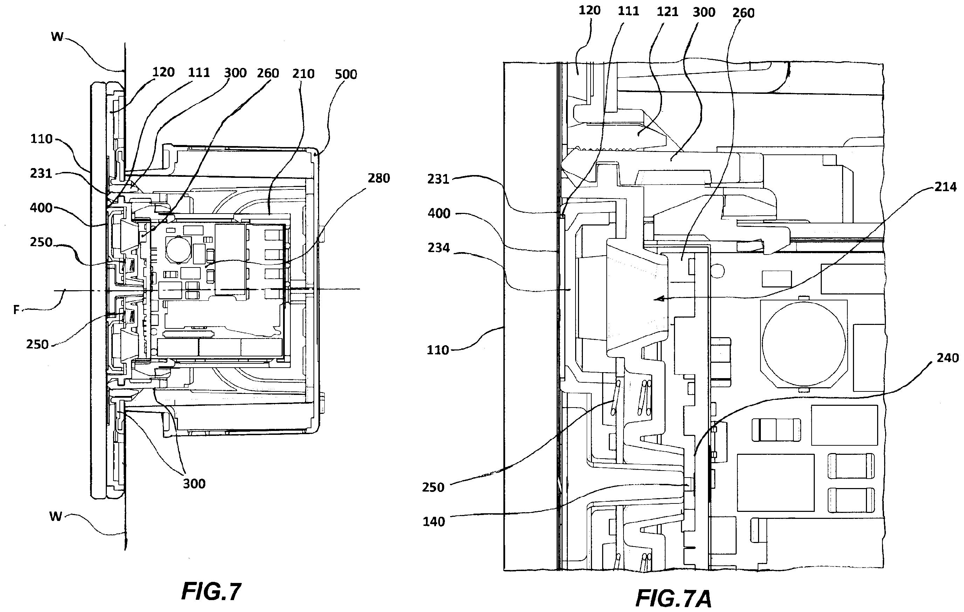

These edges 231 are designed to abut on an inner surface 111 of the actuation plate 100 opposite the cover surface 110, as shown in Figs. 7 and 7A.

Again with reference to Fig. 5A, the abutment member 230 is preferably secured in a sliding manner to the front body 211 which, to that end, comprises a plurality of through cavities 215 within which an elongate extension 233 of the abutment member 230 is housed in a sliding manner.

The elongate extension 233 advantageously has a widened end 235 which has an end of stroke function. The widened end 235 is also preferably wedge shaped so that it can be inserted in the relative through cavity 215 following a slight deformation of the material and make it possible at the same time to provide the end of stroke function described above.

According to a preferred embodiment, the elongate extensions 235 are housed in the respective cavities 215 with sufficient play not only to enable a movement in translation in the fastening direction F, but also to enable at least minimal movements in rotation of the abutment member 230 about the two axes perpendicular to the fastening direction F or, as an alternative, about at least one of these axes. It will nevertheless be appreciated that similar movement possibilities may be also achieved by different couplings with play.

In order to oppose the displacement of the abutment member 230 in the fastening direction F or its rotation about the above-mentioned axes, the control device further comprises second resilient means embodied, in the present embodiment, by a pair of helical springs 250.

The abutment member 230 also has an opening 232, facing the opening 212 provided in the front body 211, in order to enable the passage of the pins 140 and their contact with the respective conducting surface 240.

It should also be noted that when the actuation plate 100 is secured to the control device 200, the edges 231 are located at respective touch zones T of the cover surface 110 shown diagrammatically in Fig. 3A. The sensor member 130 and the relative controlling unit 280 are thus embodied such that each touch zone corresponds to a different control function of an electrical apparatus to which the control unit 1 is connected. A first touch zone T may, for instance, be provided such that when it is touched the apparatus is turned on, and when a second zone T is touched, it is turned off. In addition, contact with the touch zones T may also be associated with functions other than the simple turning on or off of apparatus, for instance a prolonged touch may vary the light intensity of a lamp.

In order to identify the touch zones T, the control device 200 further comprises a lighting device 260, shown diagrammatically in Fig. 7A and embodied by way of example as an LED.

The light projected by the lighting device 260 is projected towards the inner surface 111 of the plate 100 via a passage 214 of frustoconical shape defined in the front body 211 and a transparent surface 234 of the abutment member 230 whose perimeter corresponds with the edge 231.

The transparent surface 234 is associated with a graphical symbol 401 which may be advantageously formed by an appropriately shaped support portion 400, preferably adhesive, or also partially transparent itself, secured to the transparent surface 234. The support surface 400 is advantageously opaque and a cut or transparent window is provided in it and is shaped in accordance with the graphical symbol 401. In this way, a light image of the graphical symbol 401 is projected onto the contact surface 110 of the plate 100, advantageously at a touch zone T, making it possible to identify the function associated with that specific touch zone. As mentioned above, the plate 110a is coated so as to enable the passage of the light emitted by the lighting device 260, without, however, making the other components lying below the plate 100 visible. This feature makes it possible to provide the control unit 1 with optimum aesthetic characteristics.

According to a preferred embodiment, the lighting device 260 is advantageously associated with a proximity sensor device which turns it on when a finger - or another body or means - is detected in the vicinity of the contact surface 110. To this end, the proximity sensor device is capable of detecting the user's finger approaching within a predetermined distance, defined by a specific area facing the contact surface 110.

Advantageously, the proximity sensor may be formed by means of the sensor member 130 itself, for instance by defining one or a plurality of proximity zones P, disposed for instance around the perimeter of the touch zone T, associated to second capacitor members which are more sensitive than the ones of the touch zones T. In this way, the surface capacitance variation which takes place following the presence of a finger may be detected by the proximity zone P without actual contact with the contact surface 110.

It should be noted in this respect that, although the contact action may be detected when the contact surface 110 is almost touched, and the finger is therefore brought to a minimal distance from it without actually touching it, the distance from which the proximity sensor is able to detect the presence of a finger is much greater than that of the contact sensor and preferably differs by at least an order of magnitude. By way of example, when it is possible to detect the contact action even when the surface is almost touched, a maximum working distance of the contact sensor may be a few millimetres, while, in contrast, the maximum working distance of the proximity sensor may, by way of example, be 10-15 cm.

This feature may for instance be obtained by providing capacitor members able to detect the proximity of a finger whose dimensions are greater than those used for detecting the contact action, so as to associate the latter with a greater electrical capacitance variation at the same distance of the finger, which can therefore be detected at the distances mentioned above.

As a result of this feature, it is therefore possible to activate or intensify the back-lighting produced by the lighting device 260, thus in general vary the intensity of the light emitted, in such a way as to guide users as they move closer to the touch zones T which may be readily distinguished. To that end, it may be further provided that in the control unit of the present invention, only active touch zones are lit, i.e. zones which, when touched, actually cause a variation in the state of the apparatus to be controlled. More in general, the controlling unit 280 will be capable of selecting the lighting devices 260, which light intensity is to be varied, according to an operative state of the electronic apparatus. By way of example, when the control unit 1 is used to control apparatus for lighting an environment, a touch zone T for turning on the light and a touch zone T for turning it off may be provided.

These zones are typically disposed one above the other and the above-described function advantageously makes it possible solely to show the active zone (i.e. the zone corresponding to the light being on when it is turned off and vice-versa).

According to a preferred embodiment, the lighting device 260, once turned on or intensified following detection of the proximity of a finger or other means, returns to the previous state - turned off or at a reduced light intensity - after a certain time interval. It will be appreciated that this feature makes it possible to save energy and to avoid the presence of a source of light which the user may, in various situations, find annoying.

With reference to Fig. 5A, the control device 200 further comprises at least one switch 270 which is actuated by moving the abutment member 230 beyond a predetermined distance in the fastening direction F.

In other words, from the position at which the abutment member 230 is furthest from the front body 211, the abutment member 230 is free to move a certain distance in the fastening direction F without touching the switch 270. Once in contact with the switch 270, a further displacement of the abutment member 230 causes it to be actuated.

Each switch 270 is connected to the controlling unit 280 and is operationally associated with a respective touch zone T so that the actuation of the switch 270 produces the same function as is associated with contact with the respective zone T.

This feature advantageously makes it possible to be able to control the electrical apparatus by means of the control unit 1 even when the actuation plate 100 is not fitted, for instance during installation or maintenance of plant or in particular situations in which the plate 100, visible when the control unit is operating normally, could become dirty or broken.

The operation of the control unit 1 of the present invention is shown diagrammatically in Figs. 7 and 7A.

As illustrated above, installation of the control unit takes place by means of the fastening frame 300 on which the control device 200 is secured by a snap-locking connection.

Typically, the fastening frame 300 is in turn secured on the box-shaped body 500, inserted into the wall W, for instance by means of a threaded connection.

Any positioning errors of the box-shaped body, in particular in terms of alignment with the wall are also transmitted to the fastening frame 300 and, in turn, to the control device 200.

Once the control device 200 is fitted, the actuation plate is secured thereto, preferably by means of a plurality of arms 121 which extend from the frame 120 in the fastening direction F and may be engaged in corresponding seats 302 provided on the fastening frame 300 and illustrated in Fig. 6.

The arms 121 have a surface provided with a plurality of recesses in which a pawl (not shown) projecting from the seat 302 may be engaged.

In this way, the arms 121 may be engaged in a plurality of operating configurations spaced from one another in the fastening direction F.

However, it is evident that, in alternative to the arms 121 engageable in the respective seat 302, the use of a different retaining member 121 capable of preventing the actuation plate 100 from moving with respect to the base structure 210 at least in a direction opposite the fastening direction F can be envisaged.

Once the arms 121 are inserted in the respective seats 302, the plate 100 may therefore be urged into contact with the wall W and bear thereon, covering the control device 200, the fastening frame 300 and a wall portion extending around its perimeter.

It will be appreciated that the abutment member 230 and the control device 200 are dimensioned such that when the latter is secured to the wall W, the edges 231 project at least partially from the surface of the wall.

In this way, when the plate 100 is fitted, the edges 231 abut on the inner surface 111 and are recalled towards the front body 211 in opposition to the resilient means 250.

As a result of the movement capacity offered by the abutment member 230 with respect to the base structure 210 of the control device 200, the edges 231 may abut on the inner surface 111 even in the event of installation errors or irregularities in the surface of the wall W.

This feature makes it possible to ensure contact between the edges 231 and the surface 111 thus ensuring that a clear image is projected onto the cover surface 110.

A similar compensation effect is also provided by the electrical connector 140 which is appropriately recalled into the relative seat after the actuation plate 100 has been secured on the control device.

The invention thus resolves the stated problem and at the same time provides a number of advantages. In particular, the structure of the control unit of the present invention enables simple personalisation of the graphical symbol 400, requiring for that purpose only the replacement of the control device 100 or, more advantageously, solely of the adhesive portion on which the symbol is shown.

Moreover, the movement capacity of the abutment member 230, which makes it possible to keep an edge of the member in abutment on the inner surface 111 even in the event of installation errors or irregularities, advantageously enables a clear and sharp projection of the graphical symbol onto the contact surface 110.

In addition, a correct electrical contact between the actuation plate and the control device 200 is readily ensured by means of the compensation capacity of the electrical connection means of the control unit of the present invention. In this way, a rapid and correct assembly of the device may be ensured at the installation stage, helping therefore to enable its personalization.

Moreover, the use of the moving electrical connector, able to abut on the relative conducting surface makes it possible, with respect to other electrical connections, to compensate for any errors in the centring of the plate by means of a solution whose dimensions are particularly compact.

A further advantage lies in the possibility of actuating the lighting device and at the same time displaying the graphical symbols following only the presence of a finger in the proximity of the plate 100 with a consequent energy saving and less of a visual impact for the user.

To this regard, it is particularly advantageous the use of capacitor members that can be advantageously used for detecting both the approach of the finger to the plate, and the contact action.

Lastly, the control unit of the present invention may advantageously also be actuated without the relative plate 100, which is a particularly desirable feature during operations to maintain the electrical plant or the building in which it is installed.

## Claims

1. A control unit (1) for controlling an electrical apparatus, comprising a control device (200) adapted to be wall-mounted and an actuation plate (100) adapted to be secured to said control device (200), wherein the actuation plate (100) comprises:
• a support frame (120) and a relative cornice (122) to which a plate (110a) made of a transparent material is secured,
• a cover surface (110), defined by the plate (110a), which is at least partially transparent, said cover surface (110) being disposed, in use, to cover the control device (200) and a portion of a wall on which the control device (200) is mounted,
• a sensor member (130) adapted to detect contact with a user's finger, and wherein said control device (200) comprises:
• a base structure (210) adapted to fasten said control device (200) to the wall,
• a terminal block (220) adapted to electrically connect the control unit (1) to the electrical apparatus,
• a lighting device (260) designed to light, in use, an inner surface (111) of said actuation plate (100) opposite said cover surface (110) at a touch zone (T); wherein said control device (200) further comprises an abutment member (230) comprising an edge (231) designed to abut on said inner surface (111), said abutment member (230) being connected to said base structure (210) in such a way as to enable the edge (231) at least to move in translation in a fastening direction (F), said fastening direction (F) being a direction of pressing said actuation plate (100) on said control device (200), and wherein said control device (200) further comprises a retaining member (121) capable of preventing said actuation plate (100) from moving with respect to said base structure (210) at least in a direction opposite said fastening direction (F) and resilient means (250) designed to counter the displacement of said abutment member (230) in said fastening direction (F), wherein said touch zone (T) is adjacent to said edge (231), said abutment member (230) comprising a transparent surface (234) associated with a graphical symbol (401) facing said lighting device (260).

2. A control unit (1) according to claim 1, wherein said abutment member (230) is connected to said base structure (210) by means of a coupling with play (215, 233) in such a way as to enable at least limited rotations about an axis perpendicular to said fastening direction (F).

3. A control unit (1) according to claim 1 or 2, comprising electrical connection means (140, 240) between said actuation plate and said control device, said electrical connection means being connected or connectable to said terminal block (220) and comprising at least one electrical connector (140) which may move in said fastening direction (F) with respect to said support frame (120) and/or with respect to said base structure (210).

4. A control unit (1) according to claim 3, wherein said electrical connection means (140, 240) comprise further resilient means (141) designed to counter the displacement of said electrical connector (140) in said fastening direction (F).

5. A control unit (1) according to any of the preceding claims, further comprising at least one opaque support portion (400) facing said lighting device (260) and underlying said inner surface (111), a transparent window designed to represent said graphical symbol (401) being defined in said support portion (400) and wherein said actuation plate (100) comprises a layer of partially opaque varnish.

6. A control unit (1) according to any of the preceding claims, wherein said actuation plate (100) comprises a contact sensor device for detecting a contact action by a finger of a user or other body at the touch zone (T), a controlling unit (280) for controlling the electrical apparatus as a function of the detection of the contact action and a proximity sensor device able to execute a variation of light intensity of the illuminating device (260) following an approaching action of a finger of the user, or other body, within a predetermined distance.

7. A control unit (1) according to claim 6, further comprising a sensor element (130) comprising at least one capacitive element for detecting the contact and/or approaching action within the predetermined distance.

8. A control unit (1) according to claim 7, comprising at least a first and a second capacitive element, which are associated with the contact sensor device and with the position sensor device respectively, the second capacitive element being arranged perimetrically to the first capacitive element.

9. A control unit (1) according to claim 8, comprising a plurality of first capacitive elements, the first capacitive elements being associated with respective touch zones (T) arranged internally to a proximity area (P) defined by the second capacitive element.

10. A control unit (1) according to one of claims 6-9, wherein the predetermined distance is between 15 and 5 cm.

11. A control unit (1) according to any of the preceding claims, further comprising a switch (270) which may be actuated by moving the abutment member (230) beyond a predetermined distance in the fastening direction (F).

## Patentansprüche

1. Steuereinheit (1) zum Steuern einer elektrischen Vorrichtung, die eine zur Wandmontage eingerichtete Steuervorrichtung (200) und eine zum Befestigen an der Steuervorrichtung (200) eingerichtete Betätigungsplatte (100) umfasst, wobei die Betätigungsplatte (100) aufweist:
• einen Stützrahmen (120) und ein zugehörigen Gesims (122), an dem eine Platte (110a) aus transparentem Material befestigt ist,
• eine durch die Platte (110a) definierte Abdeckfläche (110), die zumindest teilweise transparent ist, wobei die Abdeckfläche (110) im Gebrauch so angeordnet ist, dass sie die Steuervorrichtung (200) und einen Teil einer Wand abdeckt, an der die Steuervorrichtung (200) angebracht ist,
• ein Sensorelement (130), das zum Erfassen eines Kontakts mit dem Finger eines Benutzers eingerichtet ist, und wobei die Steuerungsvorrichtung (200) umfasst:
• eine Basisstruktur (210), die zum Befestigen der Steuervorrichtung (200) an der Wand eingerichtet ist,
• einen Anschlussblock (220), der zum elektrischen Verbinden der Steuereinheit (1) mit der elektrischen Vorrichtung eingerichtet ist,
• eine Beleuchtungsvorrichtung (260), die im Gebrauch zum Beleuchten einer Innenfläche (111) der Betätigungsplatte (100) gegenüber der Abdeckfläche (110) in einer Berührungszone (T) eingerichtet ist;
wobei
die Steuervorrichtung (200) ferner ein Anschlagelement (230) mit einem Rand (231) umfasst, das zum Anliegen an der Innenfläche (111) eingerichtet ist, wobei das Anschlagelement (230) derart mit der Basisstruktur (210) verbunden ist, dass der Rand (231) zumindest translatorisch in einer Befestigungsrichtung (F) bewegbar ist, wobei die Befestigungsrichtung (F) eine Anpressrichtung der Betätigungsplatte (100) an die Steuervorrichtung (200) ist, und wobei
die Steuervorrichtung (200) ferner ein Halteelement (121), das imstande ist, zu verhindern, dass sich die Betätigungsplatte (100) in Bezug auf die Basisstruktur (210) zumindest in einer der Befestigungsrichtung (F) entgegengesetzten Richtung bewegt, und eine elastische Einrichtung (250) umfasst, die zum Entgegenwirken der Verschiebung des Anschlagelements (230) in der Befestigungsrichtung (F) ausgebildet ist, wobei die Berührungszone (T) an den Rand (231) angrenzt, wobei das Anschlagelement (230) eine transparente Oberfläche (234) aufweist, die mit einem graphischen Symbol (401) verbunden ist, das der Beleuchtungsvorrichtung (260) zugewandt ist.

2. Steuereinheit (1) nach Anspruch 1, wobei das Anschlagelement (230) mit der Basisstruktur (210) mittels einer Verbindung mit Spiel (215, 233) derart verbunden ist, dass zumindest begrenzte Drehungen um eine Achse senkrecht zur Befestigungsrichtung (F) möglich sind.

3. Steuereinheit (1) nach Anspruch 1 oder 2, die eine elektrische Verbindungseinrichtung (140, 240) zwischen der Betätigungsplatte und der Steuervorrichtung aufweist, wobei die elektrische Verbindungseinrichtung mit dem Anschlussblock (220) verbunden ist oder verbindbar ist
und zumindest einen elektrischen Verbinder umfasst, der in der Befestigungsrichtung (F) in Bezug auf den Stützrahmen (120) und/oder in Bezug auf die Basisstruktur (210) bewegbar ist.

4. Steuereinheit (1) nach Anspruch 3, wobei die elektrische Verbindungseinrichtung (140, 240) eine weitere elastische Einrichtung (141) umfasst, die zum Entgegenwirken der Verschiebung des elektrischen Verbinders (140) in der Befestigungsrichtung (F) ausgebildet ist.

5. Steuereinheit (1) nach einem der vorhergehenden Ansprüche, die ferner zumindest einen undurchsichtigen Stützbereich (400) aufweist, welcher der Beleuchtungsvorrichtung (260) zugewandt ist und unter der Innenfläche (111) liegt, ein transparentes Fenster, das zum Darstellen des graphischen Symbols (401) ausgebildet ist, das im Trägerbereich (400) definiert ist, und wobei die Betätigungsplatte (100) eine Schicht aus teilweise undurchsichtigem Lack aufweist.

6. Steuereinheit (1) nach einem der vorhergehenden Ansprüche, wobei die Betätigungsplatte (100) eine Kontaktsensorvorrichtung zum Erfassen eines Kontaktvorgangs durch einen Finger eines Benutzers oder eines anderen Körpers an der Berührungszone (T) einer Steuereinheit (280) zum Steuern der elektrischen Vorrichtung in Abhängigkeit von der Erfassung des Kontaktvorgangs, und eine Näherungssensorvorrichtung aufweist, die zum Ausführen einer Änderung der Lichtintensität der Beleuchtungsvorrichtung (260) imstande ist, die einem Annäherungsvorgang eines Fingers des Benutzers, oder eines anderen Körpers, innerhalb eines vorgegebenen Abstands folgt.

7. Steuereinheit (1) nach Anspruch 6, die ferner ein Sensorelement (130) umfasst, das mindestens ein kapazitives Element zum Erfassen des Kontakts und/oder des Annäherungsvorgangs innerhalb des vorgegeben Abstands aufweist.

8. Steuereinheit (1) nach Anspruch 7, die zumindest ein erstes und ein zweites kapazitives Element umfasst, die jeweils mit der Kontaktsensorvorrichtung und der Positionssensoreinrichtung verbunden sind, wobei das zweite kapazitive Element perimetrisch zum ersten kapazitiven Element angeordnet ist.

9. Steuereinheit (1) nach Anspruch 8, die eine Vielzahl von ersten kapazitiven Elementen umfasst, wobei die ersten kapazitiven Elemente jeweiligen Berührungszonen (T) verbunden sind, die intern an einem durch das zweite kapazitive Element definierten Nahbereich (P) angeordnet sind.

10. Steuereinheit (1) nach einem der Ansprüche 6 - 9, wobei der vorgegebene Abstand zwischen 15 und 5 cm beträgt.

11. Steuereinheit (1) nach einem der vorhergehenden Ansprüche, die ferner einen Schalter (270) aufweist, der durch Bewegen des Anschlagelements (230) über eine vorgegebene Strecke in der Befestigungsrichtung (F) hinaus betätigbar ist.

## Revendications

1. Unité de commande (1) destinée à contrôler un appareil électrique, comprenant un dispositif de commande (200) adapté pour être monté au mur et une plaque d'actionnement (100) adaptée pour être fixée sur ledit dispositif de commande (200), dans laquelle la plaque d'actionnement (100) comprend :
- un châssis de support (120) et une corniche (122) sur laquelle une plaque (110a) composée d'un matériau transparent est fixée,
- une surface de recouvrement (110), définie par la plaque (110a), qui est au moins partiellement transparente, ladite surface de recouvrement (110) étant disposée, pendant l'utilisation, afin de recouvrir le dispositif de commande (200) et une partie d'un mur sur lequel le dispositif de commande (200) est monté,
- un capteur (130) adapté pour détecter un contact avec le doigt d'un utilisateur,
et dans lequel ledit dispositif de commande (200) comprend :
- une structure de base (210) adaptée pour fixer ledit dispositif de commande (200) sur le mur,
- un bornier (220) adapté pour relier électriquement l'unité de commande (1) à l'appareil électrique,
- un dispositif d'éclairage (260) conçu pour éclairer, pendant l'utilisation, une surface intérieure (111) de ladite plaque d'actionnement (100) opposée à ladite surface de recouvrement (110) au niveau d'une zone de contact (T) ;
dans laquelle
ledit dispositif de commande (200) comprend en outre un élément de butée (230) comprenant un bord (231) conçu pour buter sur ladite surface intérieure (111), ledit élément de butée (230) étant relié à ladite structure de base (210) de façon à permettre au bord (231) de se déplacer au moins en translation dans une direction de fixation (F), ladite direction de fixation (F) étant une direction de pression de ladite plaque d'actionnement (100) sur ledit dispositif de commande (200), et dans laquelle ledit dispositif de commande (200) comprend en outre un élément de retenue (121) capable d'empêcher ladite plaque d'actionnement (100) de se déplacer par rapport à ladite structure de base (210) au moins dans une direction opposée à ladite direction de fixation (F) et un moyen flexible (250) conçu pour contrer le déplacement dudit élément de butée (230) dans ladite direction de fixation (F), dans laquelle ladite zone de contact (T) est adjacente audit bord (231), ledit élément de butée (230) comprenant une surface transparente (234) associée à un symbole graphique (401) face audit dispositif d'éclairage (260).

2. Unité de commande (1) selon la revendication 1, dans laquelle ledit élément de butée (230) est relié à ladite structure de base (210) à l'aide d'un accouplement avec un jeu (215, 233) de façon à permettre au moins des rotations limitées autour d'un axe perpendiculaire à ladite direction de fixation (F).

3. Unité de commande (1) selon la revendication 1 ou 2, comprenant un moyen de connexion électrique (140, 240) entre ladite plaque d'actionnement et ledit dispositif de commande, ledit moyen de connexion électrique étant relié ou pouvant être relié audit bornier (220) et comprenant au moins un connecteur électrique (140) qui peut se déplacer dans ladite direction de fixation (F) par rapport audit châssis de support (120) et/ou par rapport à ladite structure de base (210).

4. Unité de commande (1) selon la revendication 3, dans laquelle ledit moyen de connexion électrique (140, 240) comprend un autre moyen flexible (141) conçu pour contrer le déplacement dudit connecteur électrique (140) dans ladite direction de fixation (F).

5. Unité de commande (1) selon l'une quelconque des revendications précédentes, comprenant en outre au moins une partie de support opaque (400) tournée vers ledit dispositif d'éclairage (260) et sous ladite surface intérieure (111), une fenêtre transparente conçue pour représenter ledit symbole graphique (401) définie dans ladite partie de support (400), et dans laquelle ladite plaque d'actionnement (100) comprend une couche de vernis partiellement opaque.

6. Unité de commande (1) selon l'une quelconque des revendications précédentes, dans laquelle ladite plaque d'actionnement (100) comprend un capteur de contact destiné à détecter une action de contact par un doigt d'un utilisateur ou tout autre corps au niveau de la zone de contact (T), une unité de contrôle (280) destinée à contrôler l'appareil électrique en fonction de la détection de l'action de contact et un capteur de proximité capable d'exécuter une variation d'intensité lumineuse du dispositif d'éclairage (260) après une action d'approche d'un doigt de l'utilisateur, ou de tout autre corps, à une distance prédéterminée.

7. Unité de commande (1) selon la revendication 6, comprenant en outre un capteur (130) comprenant au moins un élément capacitif destiné à détecter l'action de contact et/ou d'approche à la distance prédéterminée.

8. Unité de commande (1) selon la revendication 7, comprenant au moins un premier et un second éléments capacitifs, qui sont associés au détecteur de contact et au capteur de position, respectivement, le second élément capacitif étant prévu de manière périmétrique par rapport au premier élément capacitif.

9. Unité de commande (1) selon la revendication 8, comprenant une pluralité de premiers éléments capacitifs, les premiers éléments capacitifs étant associés à des zones de contact respectives (T) prévues en interne par rapport à une zone de proximité (P) définie par le second élément capacitif.

10. Unité de commande (1) selon l'une des revendications 6 à 9, dans laquelle la distance prédéterminée est comprise entre 15 et 5 cm.

11. Unité de commande (1) selon l'une quelconque des revendications précédentes, comprenant en outre un commutateur (270) qui peut être actionné en déplaçant l'élément de butée (230) au-delà d'une distance prédéterminée dans la direction de fixation (F).
